Europäisches Patentamt

European Patent Office

Office européen des brevets

(19)

(11) Publication number: **0 087 479**

**A1**

(12) **EUROPEAN PATENT APPLICATION**

published in accordance with Art. 158(3) EPC

(21) Application number: 82902697.0

(22) Date of filing: 10.09.82

Data of the international application taken as a basis:

(86) International application number:
PCT/JP82/00366

(87) International publication number:
WO83/00950 (17.03.83 83/07)

(51) Int. Cl.³: **H 01 L 31/04**
**H 01 L 31/18, H 01 L 21/203**

(30) Priority: 11.09.81 JP 142427/81
17.09.81 JP 145482/81

(43) Date of publication of application:
07.09.83 Bulletin 83/36

(84) Designated Contracting States:
DE FR GB

(71) Applicant: KONISHIROKU PHOTO INDUSTRY CO. LTD.
No. 26-2, Nishishinjuku 1-chome Shinjuku-ku
Tokyo 160(JP)

(72) Inventor: SATO, Shigeru
Hamada Bldg.302 15-10, Minamidaira 3-chome
Hino-shi Tokyo 191(JP)

(72) Inventor: SHINDO, Masanari
1001-21, Nishiterakata-machi Hachioji-shi
Tokyo 192-01(JP)

(72) Inventor: OTA, Tatsuo
1-30-517, Fuchinobe 2-chome Sagamihara-shi
Kanagawa 229(JP)

(72) Inventor: MYOKAN, Isao The 2e San Mansion Hamura
302 1-5
Shinmeidai 2-chome Hamura-machi Nishitama-gun
Tokyo 190-11(JP)

(72) Inventor: SHIMA, Tetsuo
13-13, Kamirenjyaku 1-chome
Mitaka-shi Tokyo 181(JP)

(74) Representative: Brock, Peter William et al,
Michael Burnside & Partners 2 Serjeants' Inn Fleet
Street
London EC4Y 1HL(GB)

(54) METHOD AND DEVICE PRODUCING AMORPHOUS SILICON SOLAR BATTERY.

(57) Method of and device for producing an amorphous silicon solar battery, which has the steps of dividing a vacuum tank (50) into a plurality of deposition areas (10, 20), arranging deposition sources (1, 2) therein and moving a substrate (4) being built up so as to pass over the areas sequentially. An active layer which is made of amorphous silicone is formed on the substrate (4), and then a plurality of metallic layers are formed over the active layer.

F I G. 5

Description

## METHOD AND APPARATUS FOR PRODUCING
## AMORPHOUS SILICON SOLAR CELL

### Tchnical Field

This invention relates to a method and apparatus for producing an amorphous silicon solar cell.

### Background Art

Solar cells in general are constructed by providing a transparent electrode layer as one of the electrodes on the light-receiving side of an active layer which generates carriers on the reception of incident light, and another electrode layer on the other side. The active layer is conventionally formed by a crystalline semiconductor material consisting principally of crystalline silicon. Since a step of growing the crystal is necessary when producing the crystalline semiconductor material, however, a great deal of electric power and an extended period of time are required to produce the material and this inevitably increases the production cost.

Research and development has been done in recent years into the formation of an active layer using amorphous silicon (hereinafter referred to as "a-silicon") because a-silicon makes it possible to produce a thin film with a large area more easily and more economically than with crystalline silicon, and it provides a higher photoelectric conversion efficiency.

In order for a-silicon to exhibit a satisfactory performance as the active layer of a solar cell, it is essential that the dangling bonds of the a-silicon resulting from its amorphous crystalline structure, or its irregular orientation of atoms, are sealed off by hydrogen atoms or the like. It is known in the past that such a-silicon can be obtained primarily by glow discharge. In accordance with this glow discharge method, silane is decomposed by the plasma from a glow discharge inside a vacuum tank, and a-silicon into which hydrogen atoms have been injected is formed onto a substrate.

The a-silicon whose dangling bonds are thus sealed off makes it possible to obtain a doping effect by the use of a dopant. In other words, the conductivity type and degree of conductivity of a-silicon can be controlled, and an active layer having the desired structure for a solar cell can be formed. It is preferable that a large depletion layer is formed in the active layer. Such an active layer having a depletion layer can be obtained by use of a-silicon of a suitable type of conductivity.  More definitely, preferred structures include the so-called p-i-n structure in which an undoped layer (hereinafter referred to as an "i-type layer") is interposed between a p-type layer and an n-type layer, a p-n structure consisting of a laminate of a p-type layer and an n-type layer, a Schottky barrier type of structure in which a metallic layer of a metal having a large work function such as platinum, gold, palladium, etc., is deposited over an i-type layer, and so forth.

Though it is possible in theory, a great deal of labor and an extremely extended period of time are required to produce a-silicon providing such a desirable active layer by the glow discharge method.

In accordance with the glow discharge method, doping is effected by introducing a gaseous hydride of an element from Group III or V of the Periodic Table such as diborane, phosphine, arsine, and the like into the vacuum tank together with the silane. Although the structural state of the resultant a-silicon and the injection ratio of the impurity element into a-silicon during doping depend upon the conditions of the plasma generated by the glow discharge, it is extremely difficult to control and keep stable the plasma conditions.  In other words, it is extremely difficult to control sufficiently the ratio of the hydrogen to the concentration of the impurity element being introduced into the a-silicon. This means that there are serious problems still to be solved in conjunction with the stability, reproducibility and yield in order to obtain a-silicon having a desired state, that is, a-silicon having a type of conductivity into which an impurity element has been injected in a high concentration, and which has good characteristics.

If two or more a-silicon layers are continuously formed on a common substrate by glow discharge using the same vacuum tank, the gas inside the whole of the vacuum tank must be completely removed or replaced before the subsequent step is initiated if a dopant gas has been introduced in the preceding step. Moreover, part of the dopant used in the preceding step of forming the a-silicon layer will stick to the interior of the vacuum tank, and when glow discharge is effected in the subsequent step of forming an a-silicon layer of a different type of conductivity, not only the dopant that has stuck to the vacuum tank, but also part of the dopant introduced into the a-silicon layer that has already been formed will be discharged again and are quite naturally introduced into the a-silicon layer that is being formed in the subsequent step. As a result, if an i-type layer is formed after the formation of an n-type or p-type layer, the i-type layer will become n-type or p-type. If a p-type layer is formed after the formation of an n-type layer, and vice versa, the doping efficiency of the a-silicon layer formed in a subsequent step drops or disappears.

In the glow discharge method, further, the speed at which film forms can be as low as several angstroms per second. Moreover, the production of a thin film of a-silicon having a large area, and a uniform and homogeneous thickness depends upon plasma conditions which can not be controlled easily,and hence is extremely difficult. Thus, serious problems must be solved before a practical solar cell is produced by the glow discharge method on a large industrial scale.

A-silicon can be formed by deposition means and this method has the possibility of forming a continuous a-silicon layer required for a solar cell to have the necessary functions onto an elongated support or substrate. If this can be accomplished, solar cells can be produced at an extremely low production cost.

However, a solar cell formed on an elongated substrate is not used in this form, but is usually cut up into units of the required area. This is significant because, if the total surface of a solar cell is not effective but contains local defective areas, they can be easily removed.

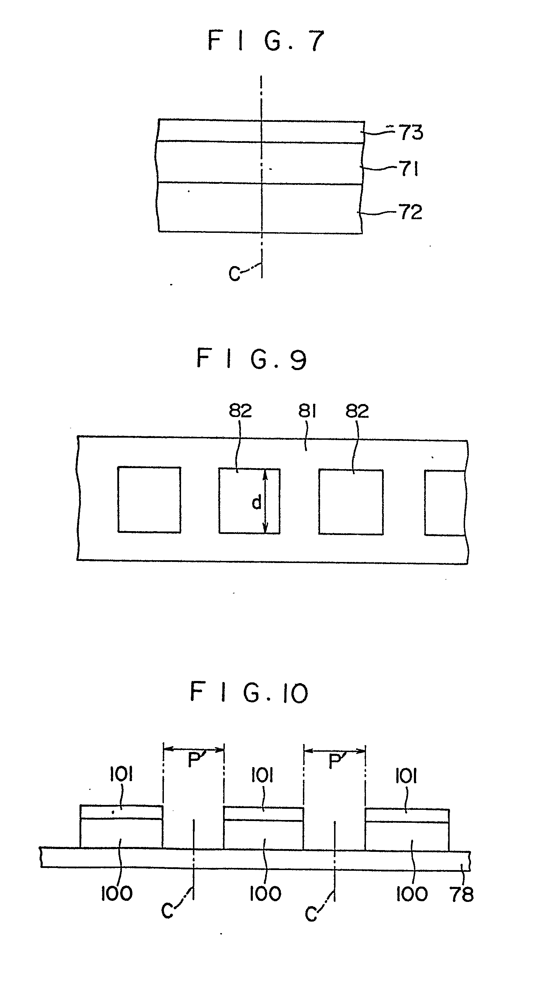

In a solar cell, however, it is necessary to provide, either directly or indirectly, a lower conductive layer 72 which consists of a metal and some times also serves as the substrate, and an upper conductive layer 73 on either side of an active layer 71, as shown in Figure 7. If a solar cell having such a construction is cut along the cutting line C, however, part of the metal or the like forming the upper or lower conductive layer 73 or 72 will be spread over the cut surfaces to make fins, so that the lower and upper conductive layers 72, 73 are connected to each other electrically causing a short-circuit, which will deprive the solar cell of its function. It is of course possible to remove the fins from individual solar cells, but this is extremely tedious to do.

### Disclosure of Invention

With the background described above, the present invention is directed to provide an apparatus for producing an a-silicon solar cell, which apparatus can easily and rapidly produce a solar cell which is equipped with an a-silicon active layer consisting of a laminate of a plurality of layers and is therefore sufficiently usable in practice, and also a solar cell which has a laminate structure of a plurality of active layers and which provides a high electromotive voltage.

It is another object of the present invention to provide a method which can produce large quantities of solar cells reliably and easily.

From the apparatus aspect, the present invention is characterized in that the apparatus consists of (a) a vacuum tank, (b) a first evaporation chamber consisting of at least one evaporation chamber and a second evaporation chamber consisting of at least one evaporation chamber, the first and second evaporation chambers being defined by dividing the vacuum tank into a plurality of chambers, (c) at least one first evaporation source provided in the first evaporation chamber consisting of at least one evaporation chamber, containing at least silicon as the evaporation source material, (d) a hydrogen discharge tube connected to the first evaporation chamber, (e) at least one second evaporation source provided inside the second evaporation chamber consisting of at least one evaporation chamber, and (f) a moving mechanism for moving an evaporation substrate so that it passes sequentially through the first evaporation chamber and the second evaporation chamber, wherein a solar cell element is constructed by a laminate of at least one a-silicon layer formed by the first evaporation source, and at least one evaporation layer formed by at least one second evaporation source, laid over the a-silicon layer.

From the process aspect, the method of the present invention is characterized by including the steps of forming an active layer consisting of a-silicon onto an elongated substrate having a conductive layer, forming a plurality of metal layers over the active layer in such a manner that they are aligned in the longitudinal direction with cutting region between them, in order to form a plurality of solar cells on the substrate, and cutting the substrate at the cutting regions to separate the individual solar cells from one another.

## Brief Description of Drawings

Figure 1 is a transverse sectional plan view of the production apparatus in accordance with the present invention;

Figure 2 is a partially cut-away front view, when viewed in the direction indicated by the arrow in Figure 1;

Figure 3 is a section of the hydrogen discharge tube shown in Figure 2;

Figure 4 is a schematic view showing an example of a solar cell produced by the apparatus of Figure 1;

Figures 5 and 6 are schematic views showing other embodiments of the present invention;

Figure 7 is a schematic view explaining the problem encountered when a large number of solar cells are produced;

Figure 8 is a schematic section showing the construction of the apparatus used for practising the method of producing solar cells in accordance with the present invention;

Figure 9 is a schematic view of the mask belt used in the present invention;

Figure 10 is a schematic view explaining one embodiment of the method of the present invention; and

Figures 11 through 13 are schematic view explaining other embodiments of the present invention.

## Best Mode for Carrying Out the Invention

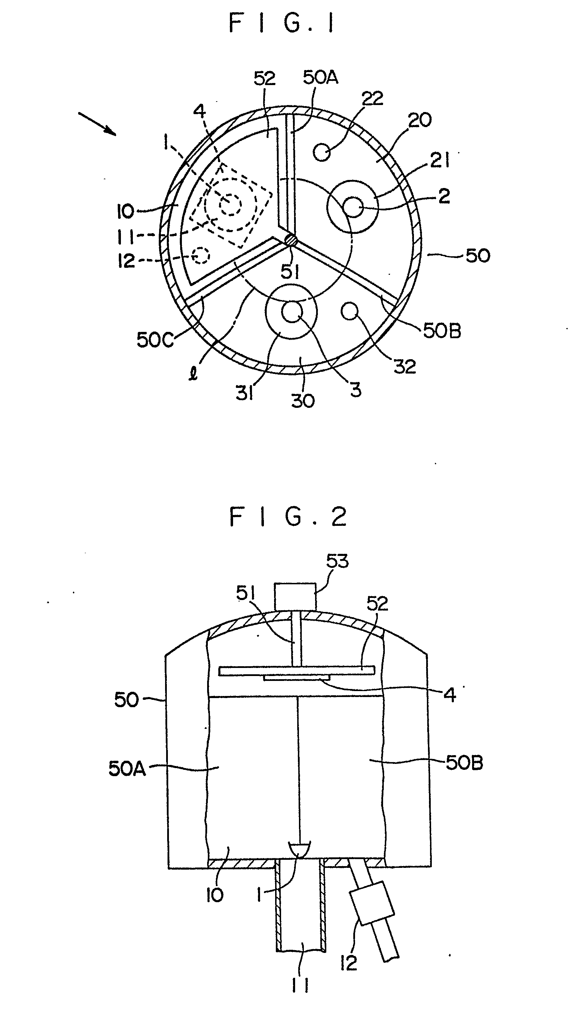

Preferred embodiments of the present invention will now be described with reference to the drawings. In the embodiment shown in Figures 1 and 2, a bell jar that constitutes the vacuum tank 50 is divided into three equal parts by dividing walls 50A, 50B, 50C so that the resultant compartments are aligned in the circumferential direction. This defines an evaporation chamber 10 for forming an n-type layer, an evaporation chamber 20 for forming an i-type layer and an evaporation chamber 30 for forming a p-type layer. An evaporation source 1 which forms an n-type layer using a mixture of an n-type semiconductor dopant selected from elements of Group V of the Periodic Table such as phosphorus, with silicon as the evaporation source material, is provided inside the n-type layer forming evaporation chamber 10. An evaporation source 2 which forms an i-type layer using only silicon as the evaporation source material

is provided inside the i-type layer forming evaporation chamber 20, and a p-type layer forming evaporation source 3 using a mixture of a p-type semiconductor dopant selected from elements of Group III such as boron, with silicon as the evaporation source material, is provided in the p-type layer forming evaporation chamber 30. Exhaust pipes 11, 21, 31 for evacuating the evaporation chambers 10, 20, 30 are connected to the base of the bell jar inside the evaporation chambers 10, 20, 30, respectively. Vacuum tanks (not shown) are connected to these exhaust pipes 11, 21, 31. The outlets of hydrogen discharge tubes 12, 22, 32 are connected to the base of the bell jar inside the evaporation chambers 10, 20, 30, respectively, so as to introduce active hydrogen and hydrogen ions into each of them. A rotary shaft 51 is provided at the center of the top of the bell jar. A support 52, which could have an arcuate shape, and which conforms with the plan shape of the evaporation chambers 10, 20, 30, is attached to the center of the top of the bell jar so that the support 52 covers the evaporation chambers 10, 20, 30 and is rotated around a circular path $\ell$ as the rotary shaft 51 rotates. A heater (not shown) is provided on the support plate 52. An evaporation substrate 4 is attached to the lower surface of the support plate 52. A driving motor 53 is connected to the rotary shaft 51. Incidentally, Figure 1 shows condition in which the support plate 52 is positioned in the n-type layer forming evaporation chamber 10.

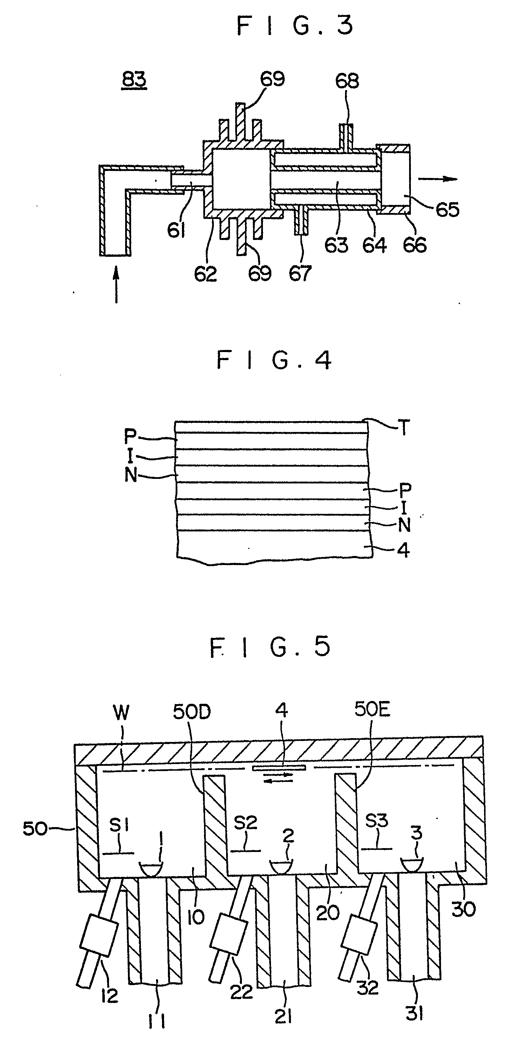

A typical example of the hydrogen discharge tube described above consists of a cylindrical electrode member 62 having a gas inlet 61 at one end, a discharge chamber member 64 made of a glass cylinder, for example, which is equipped at one of its ends with this electrode member 62 and which surrounds a discharge chamber 63, and an annular electrode member 66 having a gas outlet 65 at the other end, as shown in Figure 3. When a d.c. or a.c. voltage is applied across these electrode members 62 and 66, the hydrogen supplied through the gas inlet 61 induces a glow discharge, and active hydrogen consisting of hydrogen atoms or molecules activated by the electron energy and ionized hydrogen ions are discharged from the outlet 65. The discharge chamber member 64 shown in the drawing has a double-tube structure so that cooling water can be passed therethrough. Reference numerals 67, 68 represent a cooling water inlet and outlet, respectively, and reference numeral 69 represents cooling fins for the electrode member 62.

In the hydrogen gas discharge tube described above, the distance between the electrodes is between 10 to 15 cm, the impressed voltage is between 500 to 800 V and the pressure in the discharge chamber is approximately $10^{-2}$ Torr.

In the apparatus of the present invention having the construction described above, the active hydrogen and hydrogen ions from the hydrogen discharge tubes 12, 22, 32 are introduced into the evaporation chambers 10, 20, 30 while they are kept at a high vacuum of $10^{-2}$ to $10^{-7}$ Torr, and the evaporation sources 1, 2, 3 are heated so as to evaporate the evaporation source materials therefrom. The support plate 52 is positioned first in the n-type layer forming evaporation chamber 10, and the evaporation source material from the n-type layer forming evaporation source 1 is evaporated onto the substrate 4 to form an n-type layer. The motor 53 is then actuated and the support plate 52 is moved into the i-type layer forming evaporation chamber 20, and the evaporation source material from the i-type layer forming evaporation source 2 is evaporated onto the surface of the n-type layer to form an i-type layer. Thereafter, the motor 53 is actuated to move the support plate 52 into the p-type layer forming evaporation chamber 30, and the evaporation source material from the p-type layer forming evaporation source 3 is evaporated onto the surface of the i-type layer to form a p-type layer. The motor 53 is again actuated to move the support plate 52 in the same way around the circular path $\ell$ through the n-type layer forming evaporation chamber 10, the i-type layer forming evaporation chamber 20 and the p-type layer forming evaporation chamber 30, thereby laminating a plurality of solar cell elements each consisting of an a-silicon layer having a p-i-n structure in which the n-type layer N, the i-type layer I and the p-type layer P are laminated over the evaporation substrate 4 in that order, as shown in Figure 4. Thereafter, a transparent electrode layer T is formed over the surface to provide the a-silicon solar cell.

In the a-silicon layer formed in each of the evaporation chambers 10, 20, 30, dangling bonds are sealed by the active hydrogen and hydrogen ions. Since each evaporation chamber is separated from the others, part of the dopant used in a previous step of forming the a-silicon layer does not mix into the a-silicon layer formed in the subsequent step, and consequently an a-silicon layer having good characteristics can be obtained. Moreover, the speed of evaporation of both the dopants and the silicon can be controlled independently. Furthermore, the degree of activity and the quantity of the active hydrogen and the quantity of hydrogen ions introduced into the vacuum tank can be controlled independently by control of the quantity of hydrogen supplied through the hydrogen discharge tube and the discharge voltage, so that a p-type layer, an i-type layer and an n-type layer having the desired characteristics can be obtained.

An n-type layer, an i-type layer and a p-type layer can be laminated sequentially one upon another over the evaporation substrate 4 simply by passing the substrate 4 sequentially through the evaporation chambers 10, 20, 30 that are separated from one another, thereby eliminating the necessity of replacing the gas inside the vacuum tank every time a new a-silicon layer is formed, as is necessary in the glow discharge method. Thus, the p-i-n structure forming a satisfactory active layer, and a laminate of such a structure can be formed extremely easily.

In comparison with the glow discharge method, the speed of forming the layers of a-silicon can be increased dramatically in an easy manner. Even if the substrate has a large area, an a-silicon layer which is homogeneous not only over the surface but also through the thickness of the layer, and which has a uniform concentration of dopant as well as a uniform thickness can be formed within a short period of time. As a result, an a-silicon solar cell having a large conversion efficiency, and an a-silicon solar cell constructed of a laminate of these layers and having a high electromotive voltage, can be produced easily on an industrial scale within a short period of time.

In the embodiment of the invention described above, the evaporation substrate 4 is moved around the endless circular path ℓ and this makes it possible to form the laminate structure of p-i-n layers suitably and continuously. Three solar cells can be produced simultaneously by carrying out the evaporation procedures described above on three evaporation substrates that are positioned in the three evaporation chambers 10, 20, 30.

In the above embodiment, the first evaporation chamber, for example, is defined by the n-type layer forming evaporation chamber 10 and the i-type layer forming evaporation chamber 20, and the second evaporation chamber by the p-type layer forming evaporation chamber 30. The first evaporation source is formed by the n-type layer forming evaporation source 1 and the i-type layer forming evaporation source 2, and the second evaporation source by the p-type layer forming evaporation source 3.

Though the above is a preferred embodiment of the present invention, it is also possible to employ the following arrangement. As shown in Figure 5, the vacuum tank 50 is divided by the dividing walls 50D and 50E so that the resultant compartments are aligned in a line and form the n-type layer forming evaporation chamber 10, the i-type layer forming evaporation chamber 20 and the p-type layer forming evaporation chamber 30. The n-type layer forming evaporation source 1, the i-type layer forming evaporation source 2 and the p-type layer forming evaporation source 3 are disposed in the evaporation chambers 10, 20 and 30, respectively. The evaporation substrate 4 is made to reciprocate along the transport path W extending between the evaporation chambers 10, 20 and 30 by a transport mechanism (not shown). According to this arrangement, evaporation is effected only when the evaporation substrate 4 is moving along the forward stroke, and shutters S1, S2 and S3 for the evaporation sources 1, 2 and 3 are closed when the evaporation substrate 4 moves along the return stroke.

In the embodiment shown in Figure 5 as well as in the previous embodiment, the transport mechanism may have a construction in which the evaporation source materials are moved relative to the evaporation substrate.

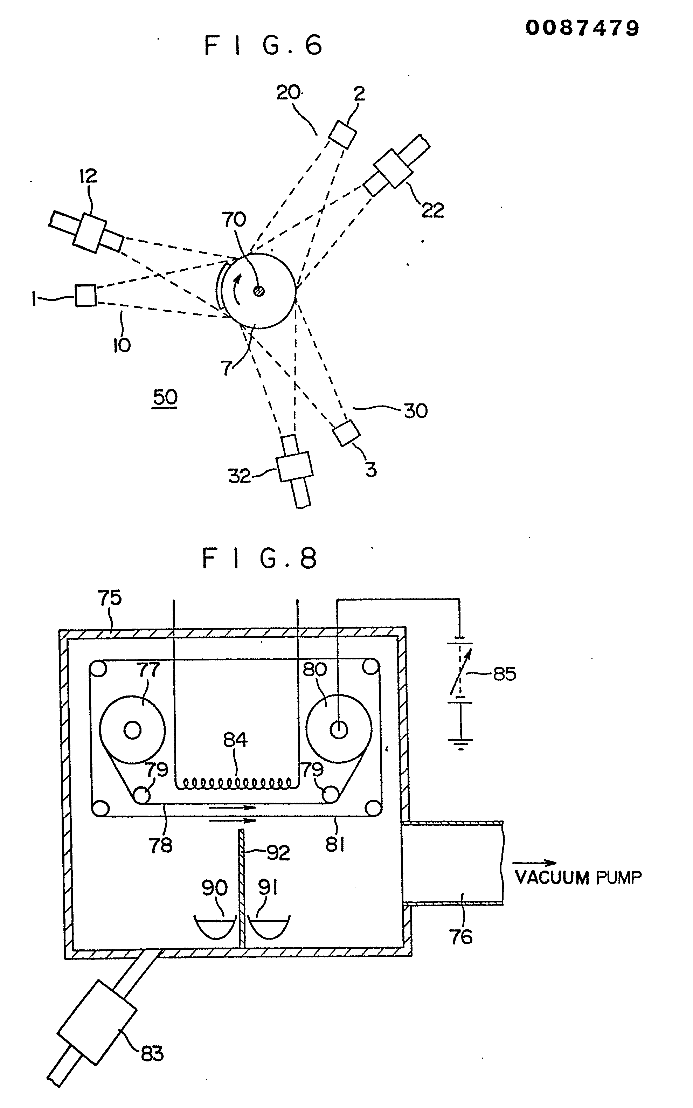

It is also possible to employ the following construction in the present invention. As shown in Figure 6, a flexible evaporation substrate 4 is bonded to the circumferential surface of a drum 7 that is rotated around a perpendicular shaft 70, and the drum 7 is rotated by a moving mechanism (not shown) so that the evaporation substrate 4 is sequentially positioned in an n-type layer forming evaporation chamber 10, an i-type layer forming evaporation chamber 20 and a p-type layer forming evaporation chamber 30 that are separated so as to be aligned in the circumferential direction with one another. In such a case, each evaporation source is disposed in such a manner as to face obliquely upward.

When forming the evaporation chambers by dividing a vacuum tank in the present invention, dividing walls are not always necessary. For example, in the embodiment shown in Figure 5, the evaporation chamber for each evaporation source may be separated from the others so that evaporation sources do not overlap one another.

In the present invention, it is possible to provide an evaporation source containing therein the dopant for the n-type semiconductor and another evaporation source containing only silicon so as to form the n-type layer forming evaporation source from them, and to provide an evaporation source containing the dopant for the p-type semiconductor and another evaporation source containing only silicon so as to form the p-type layer forming evaporation source from them.

In accordance with the present invention, a solar cell with a p-n structure can also be produced. In this case, the vacuum tank is divided into two evaporation chambers such as the p-type layer forming chamber and the n-type layer forming chamber so that a p-type layer forming evaporation source and an n-type layer forming evaporation source are provided in the p-type layer forming evaporation chamber and the n-type layer forming evaporation chamber, respectively.
A solar cell having a Schottky barrier type of structure can also be produced, for example. In such a case, an evaporation source containing therein the evaporation source material containing silicon is provided in the first evaporation chamber, and a metal evaporation source containing therein a metal having a large work function such as platinum, gold, palladium, etc., can be provided in the second evaporation chamber.

Thus, the production apparatus in accordance with the present invention can produce solar cells having various structures such as a p-i-n structure, a p-n structure, a Schottky barrier type and so forth. In any of these cases, the thickness of each layer of a-silicon and the overall structure must be considered by controlling the speed of evaporation of the evaporation source, or by changing the time during which the evaporation substrate is inside the evaporation chamber, for example, in order that the resultant solar cells completely absorb sunlight, and to obtain the maximum conversion efficiency.

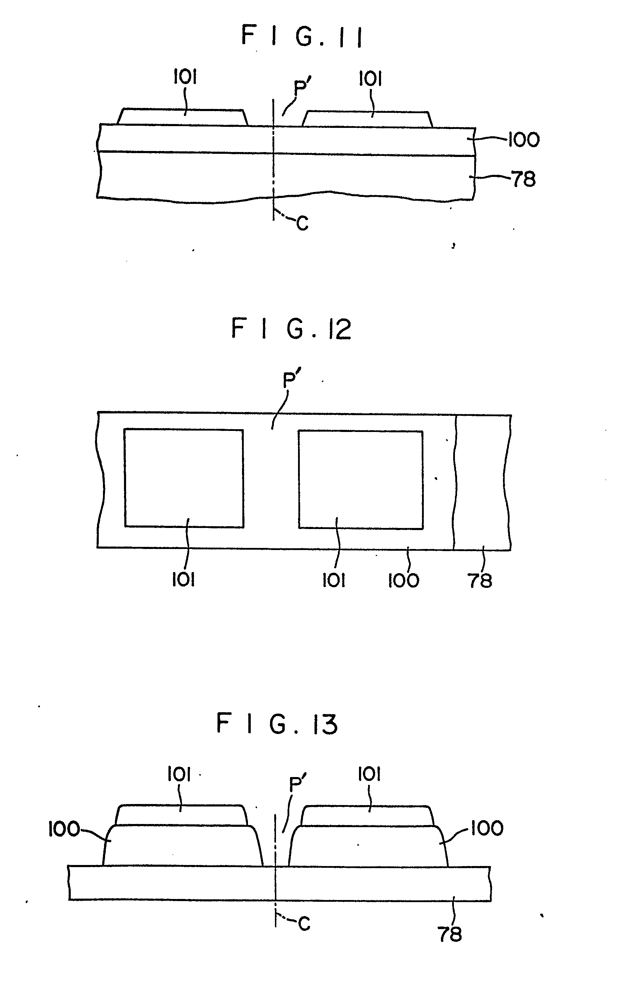

In accordance with the present invention, a plurality of a-silicon solar cells can be formed on an elongated support having a conductive layer. For example, a vacuum tank 75 is exhausted to a vacuum of $10^{-3}$ to $10^{-7}$ Torr by a vacuum pump (not shown) connected to an exhaust passage 76, as shown in Figure 8, and a silicon evaporation source 90 and a metal evaporation source 91 are provided in the vacuum tank 75 that is divided into evaporation compartments by a dividing wall 92. An elongated conductive substrate 78 is conveyed and guided by guide rollers 79 from a substrate roller 77 so as to pass through a substrate passage positioned above the evaporation sources. The substrate 78 is taken up by a take-up roller 80. An endless mask belt 81 is disposed in such a manner that it is conveyed together with the substrate 78 on the surface of the substrate 78 facing the silicon evaporation source 90. Rectangular windows 82, 82 having a width d smaller than the width of the substrate 78 are formed in the mask belt 81 so as to be separated from each other in the longitudinal direction as shown in Figure 9. The outlet of a hydrogen discharge tube 83 is connected to the vacuum tank 75 so as to face the substrate passage. The substrate 78 is heated by a heater 84 to a temperature of 150 to 500°C, preferably 250 to 450°C. While a d.c. negative voltage of 0 to -10 kV, preferably -1 to -6 kV, is being applied via the take-up roller 80, for example, the substrate 78 is being conveyed, and the active hydrogen and hydrogen ions are being introduced from the hydrogen discharge tube 83 into the vacuum tank 75. The silicon evaporation source 90 is heated to evaporate the silicon, and at the same time the metal evaporation source 91 is heated to evaporate the metal so that a-silicon is first evaporated onto the surface of the substrate 78 through the windows 82 of the mask belt 81, thereby forming a large number of active layers 100, 100 consisting of a-silicon and aligned sequentially while being separated from one another by cutting regions P', as shown in Figure 10. Next, the metal is evaporated onto these active layers 100, 100 to form metal conductive layers 101. In this manner, a large number of solar cells are formed, each consisting of an active layer 100 and a metal conductive layer 101. Thereafter, the substrate 78 is cut along the cutting regions P' to separate the discrete solar cells.

In the production process described above, any heating method such as resistance heating, electron gun heating, induction heating, etc., may be employed for heating the silicon evaporation source 90, etc. It is necessary to prevent large particles of the evaporation source material from being ejected from the evaporation source and attaching to the substrate 78 due to turbulence, and to this end, a member preventing large particles from being ejected, and forming a curved evaporation passage, may be employed.

In the example of the hydrogen discharge tube 83 described above and shown in Figure 3, the tube consists of a cylindrical electrode member 62 having a gas inlet 61, a discharge chamber member 64 made of a glass cylinder, for example, which is disposed at one end of the electrode member 62 and surrounds a discharge chamber 63, and an annular electrode member as the other electrode disposed at the other end of the discharge chamber member 64. A d.c. or a.c. voltage is applied across the electrode members 62 and 66 so that the hydrogen introduced through the gas inlet 61 causes a glow discharge in the discharge chamber 63 and active hydrogen consisting of the hydrogen atoms or molecules activated by the electron energy and hydrogen ions are discharged from an outlet 65. The discharge chamber member 64 shown in this embodiment has a double tube structure in which cooling water can flow. Reference numerals 67 and 68 represent the inlet and outlet for the cooling water and reference numeral 69 represents cooling fins on one electrode members 62.

In the hydrogen discharge tube 83 described above, the distance between the electrodes is between 10 to 15 cm, the impressed voltage is between 500 to 800 V, and the pressure in the discharge chamber is approximately $10^{-2}$ Torr.

The production method in accordance with the present invention has the construction described above. Although the conductive substrate 78 forming the lower conductive layer is in common, the metal conductive layers 101 forming the upper conductive layer are separated from one another by cutting regions P'. When the substrate is cut along this cutting regions P', the conductive layers 101 are not cut, and hence fins do not develop. This eliminates the possibility that the metal conductive layer 101 and the substrate 78 are brought into mutual contact to cause a short-circuit. Hence, the function of individual solar cells is not lost, and a high reliability can be ensured. The active layer 100 of a-silicon and the metal conductive layer 101 can be formed continuously, and for this reason solar cells can be produced at a high level of productivity.

In order to form the active layer 100 in the present invention, any method can be used so long as the method can form a-silicon continuously and can form an active layer from a-silicon. In the above embodiments, the active layer 100 is formed by the evaporation of silicon in the presence of active hydrogen and hydrogen ions obtained by electric discharge of hydrogen. Accordingly, an active layer 100 consisting of a-silicon whose dangling bonds are sealed by hydrogen atoms can be formed reliably. Moreover, the degree of activity and quantity of active hydrogen, and the quantity of hydrogen ions introduced into the vacuum tank 75 can be controlled independently through the control of the temperature to which the substrate 78 is heated, control of the impressed voltage, control of the speed of evaporation of the silicon, and control of the quantity of hydrogen supplied through the hydrogen discharge tube 83 and the discharge voltage. Accordingly, a-silicon having the desired excellent characteristics can be obtained. The active layer 100 may consist not only of a single layer but also of a laminate of a plurality of layers. In such a case, a p-type or n-type a-silicon layer can be formed easily by using a further evaporation source consisting of an element from Group III of the Periodic Table such as aluminum, indium, gallium, etc., or an element from Group V of the Periodic Table such as antimony, phosphorous, arsenic, etc., for a joint evaporation. Moreover, the content of the dopant in the a-silicon can be controlled by controlling the speed of evaporation so as to obtain a p-type or n-type a-silicon.

In accordance with the production method of the present invention, the speed at which a film forms can be increased easily, and an a-silicon semiconductor layer having an increased thickness can be formed within a short period of time, and an a-silicon semiconductor layer having a uniform composition and a uniform thickness can be formed onto the elongated substrate 78.

Since the hydrogen discharge tube 83 is connected to the outside of the vacuum tank 75, the discharge in the hydrogen discharge tube 83 does not become unstable even if degasing from the substrate 78 occurs inside the vacuum tank 75, and the evaporation of the silicon or dopant can be effected extremely stably. Accordingly, an a-silicon semiconductor layer having good characteristics can be formed stably and continuously onto the elongated substrate 78, and a-silicon solar cells can be produced extremely economically.

The a-silicon thus produced on the substrate 78 is taken up by the take-up roller 80. During the period in which a-silicon is being formed over the entire surface of the substrate 78, a-silicon is kept heated in an atmospher in which there are active hydrogen and hydrogen ions, so that an annealing effect of the a-silicon can be obtained, and the a-silicon has a stable quality.

The above embodiments use an electrically conductive substrate. Examples of such substrates include stainless steel, aluminum, and the like. The present invention can also use a dielectric support such as a polyimide film, a polyamide film, and the like. In such a case, it is necessary to form a metal conductive layer over the surface of the substrate, and this can be accomplished by the evaporation of chromium, for example. The d.c. voltage could be applied by using a conductive roller that comes into contact with this metal conductive layer.

In the present invention, a shutter may be provided for the metal evaporation source 91 instead of the mask belt 81. When the shutter is periodically closed for a predetermined period of time, metal conductive layers 101 that are sequentially aligned and separated from one another by cutting regions P' as shown in Figure 11 are formed onto an active layer 100 formed continuously on the substrate, during the period in which the shutter is closed. The substrate 78 may be cut to provide individual solar cells. In this case, if the metal conductive layers 101 are formed in such a manner as to extend over the entire width of the active layer 100, the metal conductive layer 101 and the substrate 78 would come into contact with each other at both side edges and this would cause short-circuiting. Accordingly, as shown in Figure 12, a shield member is provided so as to cover both side edges of the active layer 100 while it is in the evaporation region subject to the metal evaporation source 91 in order to prevent the metal conductive layers 101 from extending over the entire width of the active layer 100. Furthermore, a shutter is also provided for the silicon evaporation source 90 and this is periodically closed for a predetermined period of time in synchronism with the shutter for the metal evaporation source 91 so as to form active layers 100 that are separated from each other by cutting regions P' on the substrate 78, as shown in Figure 13, and after a metal conductive layer 101 is formed on each of the active layers 100, the substrate can be cut.

### Industrial Applicability

As described above, the present invention can provide a method of producing large quantities of solar cells reliably and easily.

In accordance with the present invention, solar cells equipped with the active layer of a-silicon having a laminate structure of a plurality of layers, and hence having a sufficiently high practical applicability, can be produced easily within a short period of time. Furthermore, the present invention can provide a production apparatus for producing a-silicon solar cells which can easily produce solar cells having a laminate structure of a plurality of active layers and having a high electromotive voltage.

Claims

1. An apparatus for producing an amorphous silicon solar cell, comprising:

(a) a vacuum tank;

(b) a first evaporation chamber consisting of at least one evaporation chamber and a second evaporation chamber consisting of at least one evaporation chamber, said first and second evaporation chambers being defined by dividing said vacuum tank into a plurality of chambers;

(c) at least one first evaporation source disposed in said first evaporation chamber consisting of at least one evaporation chamber and containing at least silicon as the evaporation source material;

(d) a hydrogen discharge tube connected to said first evaporation chamber;

(e) at least one second evaporation source disposed in said second evaporation chamber consisting of at least one evaporation chamber; and

(f) a transport mechanism for transporting an evaporation substrate in such a manner that it passes sequentially through said first and second evaporation chambers.

2. The apparatus for producing an amorphous silicon solar cell as defined in claim 1 wherein said transport mechanism is one that transports said evaporation substrate along an endless path.

3.   A method of producing an amorphous silicon solar cell including the steps of: forming an active layer consisting of amorphous silicon onto an elongated substrate having a conductive layer; forming a plurality of metal layers onto said active layer so that said metal layers are aligned sequentially with one another in the longitudinal direction separated by cutting regions, thereby forming a plurality of solar cells on said substrate; and cutting said substrate along said cutting regions so as to separate the individual solar cells.

4.   The method of producing an amorphous silicon solar cell as defined in claim 3 wherein said step of forming said active layer is effected by evaporating silicon onto said substrate inside a vacuum tank in the presence of active hydrogen and hydrogen ions.

0087479

F I G . 1

F I G . 2

F I G . 3

F I G . 4

F I G . 5

F I G . 6

0087479

F I G . 8

VACUUM PUMP

# F I G. 7

73

71

72

C

# F I G. 9

82    81    82

d

# F I G. 10

P'    P'

101    101    101

100    C    100    C    100    78

F I G. 11

101     P'     101

100

78

C

F I G. 12

P'

101     101    100    78

F I G. 13

101    P'    101

100            100

C

78

# INTERNATIONAL SEARCH REPORT

International Application No.  PCT/JP82/00479

## I. CLASSIFICATION OF SUBJECT MATTER (if several classification symbols apply, indicate all) [3]

According to International Patent Classification (IPC) or to both National Classification and IPC

Int. Cl.³  H01L 31/04, 31/18, 21/203

## II. FIELDS SEARCHED

| Minimum Documentation Searched [4] | |
|---|---|
| Classification System | Classification Symbols |
| I P C | H01L 31/04, 31/18, 21/203 |

| | Documentation Searched other than Minimum Documentation to the Extent that such Documents are Included in the Fields Searched [5] |
|---|---|
| | Kokai Jitsuyo Shinan Koho    1971 - 1982 |

## III. DOCUMENTS CONSIDERED TO BE RELEVANT [14]

| Category* | Citation of Document, [16] with indication, where appropriate, of the relevant passages [17] | Relevant to Claim No. [18] |
|---|---|---|
| Y | JP,A, 56-104477 (Energy Conversion Devices, Inc.)  20. August. 1981  (20.08.81) Column 36, line 12 to column 37, line 9 | 1 - 4 |
| Y | JP,A, 56-114387 (Sanyo Electric Co., Ltd.). 8. September. 1981 (08.09.81) | 1 - 4 |

* Special categories of cited documents: [15]

"A" document defining the general state of the art which is not considered to be of particular relevance

"E" earlier document but published on or after the international filing date

"L" document which may throw doubts on priority claim(s) or which is cited to establish the publication date of another citation or other special reason (as specified)

"O" document referring to an oral disclosure, use, exhibition or other means

"P" document published prior to the international filing date but later than the priority date claimed

"T" later document published after the international filing date or priority date and not in conflict with the application but cited to understand the principle or theory underlying the invention

"X" document of particular relevance; the claimed invention cannot be considered novel or cannot be considered to involve an inventive step

"Y" document of particular relevance; the claimed invention cannot be considered to involve an inventive step when the document is combined with one or more other such documents, such combination being obvious to a person skilled in the art

"&" document member of the same patent family

## IV. CERTIFICATION

| Date of the Actual Completion of the International Search [2] | Date of Mailing of this International Search Report [2] |
|---|---|
| December 1, 1982 (01.12.82) | December 20, 1982 (20.12.82) |
| International Searching Authority [1] | Signature of Authorized Officer [30] |
| Japanese Patent Office | |

Form PCT/ISA/210 (second sheet) (October 1981)